# FASCICULE DE BREVET EUROPEEN

(11) **EP 2 036 142 B1**
(45) Date de publication et mention de la délivrance du brevet: **17.04.2013**
(21) Numéro de dépôt: 07803777.7
(22) Date de dépôt: 26.06.2007
(51) Int. Cl.: H01L 51/50

(54) **ÉMETTEUR ET DISPOSITIF D'AFFICHAGE ASSOCIÉ**
EMITTER UND ZUGEHÖRIGE ANZEIGEVORRICHTUNG
EMITTER AND ASSOCIATED DISPLAY DEVICE

(30) Priorité: 30.06.2006 FR 0605956
(43) Date de publication de la demande: 18.03.2009
(73) Titulaire: Thomson Licensing, 92130 Issy-les-Moulineaux (FR)
(72) Inventeur: VAUFREY, David, F-38000 Grenoble (FR); LE ROY, Philippe, F-35830 Betton (FR); PRAT, Christophe, F-44100 Nantes (FR)
(74) Mandataire: Esselin, Sophie
(86) Numéro de dépôt international: PCT/FR2007/001065
(87) Numéro de publication internationale: WO 2008/000948

(56) Documents cités:
- US-A- 2 755 457
- US-A- 3 069 596
- US-A1- 2001 001 485
- US-A1- 2004 164 671
- US-A1- 2004 207 577

## Description

Selon un premier aspect, l'invention concerne un émetteur du type comprenant deux électrodes en regard l'une de l'autre et au moins une couche organique intercalée entre ces électrodes, qui est propre à émettre de la lumière, dont l'épaisseur varie continûment entre une première et une deuxième extrémité.

Ce type d'émetteur organique est utilisé dans un dispositif d'affichage à matrice passive dans lequel les pixels sont formés par des couches organiques en forme de barrette disposées à l'intersection de lignes d'anode et de colonnes de cathode. Chaque couche organique est située entre plusieurs anodes et une cathode. Les lignes d'anodes et les colonnes de cathode sont activées séquentiellement pour qu'une partie d'une couche organique située entre une ligne d'anode et une colonne de cathode émette de la lumière.

Toutefois, ces émetteurs et leurs moyens d'adressage sont trop complexes pour être utilisés dans un dispositif d'affichage de type vu-mètre.

Il est connu de la publication de brevet US 2,755,457 d'utiliser comme émetteur, une couche inorganique émissive dont l'épaisseur varie entre ses deux extrémités. La publication US 2001/00011485 A1 décrit un dispositif d'affichage dans lequel au moins l'une des couches parmi une couche organique émissive, une couche de transport d'électrons et une couche de transport de trous, est formée en un motif à deux épaisseurs.

Selon le premier aspect, l'invention a pour but de proposer un émetteur plus simple comme décrit dans la revendication 1.

A cet effet, l'invention a pour objet un émetteur du type précité, dans lequel l'épaisseur de ladite première extrémité est inférieure à l'épaisseur de la seconde extrémité, et la tension de seuil de déclenchement de ladite première extrémité de la couche organique est inférieure à la tension de seuil de déclenchement de ladite seconde extrémité de la couche organique, et qui présente les caractéristiques de la revendication 1.

Selon un second aspect, l'invention concerne un dispositif d'affichage comme décrit dans la revendication 4.

Il est connu un dispositif d'affichage de type vumètre comprenant plusieurs diodes électroluminescentes réparties selon une ligne et connectées à un circuit de commande et à un dispositif d'alimentation propre à alimenter chaque diode par une même valeur de tension prédéfinie. Le circuit de commande est apte à recevoir un signal d'entrée et à commander de façon séquentielle et discrète l'alimentation d'un certain nombre de diodes en fonction de la valeur du signal d'entrée, de sorte que le nombre de diodes allumées soit représentatif du signal d'entrée.

Ce dispositif d'affichage est notamment utilisé dans des postes radios pour afficher la fréquence d'un signal audio.

Toutefois, ce dispositif d'affichage est compliqué.

Selon le second aspect, l'invention a pour but de proposer un dispositif d'affichage plus simple.

A cet effet, l'invention a pour objet un dispositif d'affichage comportant au moins un émetteur de lumière tel que mentionné ci-dessus, et un support de fixation de l'émetteur de lumière, et le dispositif d'affichage comporte en outre des moyens de fourniture d'une tension variable connectés à la première et à la seconde électrodes, les moyens de fourniture étant aptes à générer une première tension et une seconde tension supérieure à la première tension, la couche organique comprenant au moins une première et une seconde parties agencées entre les deux mêmes électrodes ; seule la première partie de la couche organique est apte à émettre de la lumière, lorsque la première tension est appliquée entre les électrodes et la première et la seconde parties de la couche organique sont aptes à émettre de la lumière lorsque la seconde tension est appliquée entre les électrodes.

L'invention sera mieux comprise à la lecture de la description qui va suivre, donnée uniquement à titre d'exemple et faite en se référant aux dessins, sur lesquels :
- la figure 1 est une vue schématique de côté d'un dispositif d'affichage comportant un émetteur selon un premier mode de réalisation sur laquelle le dispositif affiche une première valeur d'un signal d'entrée ;
- la figure 2 est une vue schématique de dessous du dispositif d'affichage illustré sur la figure 1, sur laquelle le dispositif affiche la première valeur du signal d'entrée ;
- la figure 3 est une vue similaire à la vue de la figure 1, sur laquelle le dispositif affiche une seconde valeur du signal d'entrée ; et
- la figure 4 est une vue similaire à la vue de la figure 2, sur laquelle le dispositif affiche la seconde valeur du signal d'entrée.

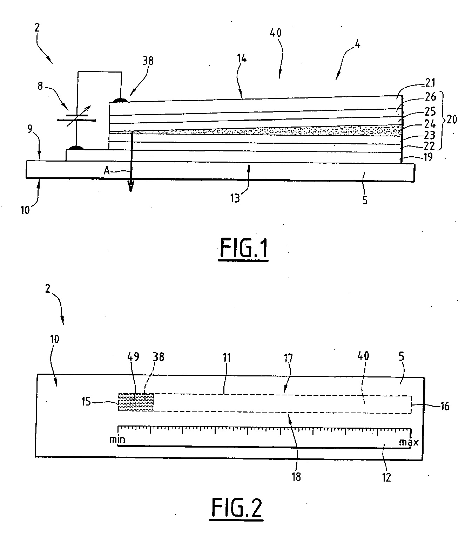

Un dispositif d'affichage 2 comportant un émetteur selon le premier mode de réalisation est illustré schématiquement sur les figures 1 et 2.

Ce dispositif d'affichage 2 est à matrice passive. Il est propre à donner une représentation graphique d'une valeur d'un signal appliqué à son entrée.

Il comporte un émetteur 4, un substrat 5 de support de l'émetteur 4 et des moyens 8 de fourniture d'une tension d'alimentation à cet émetteur 4.

Le substrat 5 est constitué d'une plaque transparente par exemple réalisée dans du verre ou du plastique. Il présente une épaisseur comprise entre 0,7 et 1,1 millimètres.

Le substrat 5 possède une première face principale 9 sur laquelle l'émetteur 4 est fixé et une seconde face principale 10 opposée à la première face principale 9.

La seconde face principale 10 comprend une zone rectangulaire 11 propre à être traversée par la lumière émise par l'émetteur 4, et une échelle graduée 12 fixée le long de la zone 11.

La zone 11 présente une forme et une dimension correspondant à la forme et à la dimension de la face de l'émetteur 4 fixée au substrat 5. La zone 11 est appelée surface d'affichage dans la suite de la description.

L'échelle 12 est graduée de façon continue sur une plage de valeurs correspondant aux valeurs possibles du signal d'entrée.

Les moyens 8 de fourniture d'une tension comprennent un générateur de tension variable propre à recevoir un signal d'entrée et à délivrer une tension de sortie.

La valeur de la tension de sortie est propre à correspondre à la valeur du signal d'entrée selon une cartographie préétablie. La cartographie est réalisée au cours d'une phase d'apprentissage pour mettre en correspondance les différentes valeurs possibles du signal d'entrée avec les valeurs de tension à appliquer à l'émetteur 4 afin que la zone éclairée de la surface d'affichage corresponde à la valeur du signal d'entrée sur l'échelle 12.

L'émetteur 4 a une forme générale de barrette parallélépipédique. Il comprend une face principale 13 fixée au substrat 5 et une face principale 14 opposée à la face 13, un côté latéral 15 disposé en vis-à-vis de la valeur minimum de l'échelle graduée 12 et un côté latéral 16 opposé au côté 15 et disposé en vis-à-vis de la valeur maximum de l'échelle graduée 12.

Il comprend également deux côtés longitudinaux 17, 18.

L'émetteur 4 comporte en outre une anode 19, une couche organique électroluminescente 20 déposée sur l'anode 19 et une cathode 21 déposée sur la couche organique 20.

L'anode 19 est constituée par une couche transparente conductrice qui est connectée à l'anode des moyens de fourniture de tension 8.

L'anode 19 est formée en oxyde d'indium et d'étain, et est généralement désignée par l'acronyme ITO. Elle présente une épaisseur constante d'environ 100 à 150 nanomètres. Elle est déposée sur l'ensemble de la surface de l'anode 19.

La couche organique 20 est constituée de plusieurs couches élémentaires dont au moins une couche est une couche organique.

En particulier, elle comprend une couche élémentaire de transport de trous 22 déposée sur l'anode 19 et une couche élémentaire de blocage d'électrons 23 déposée sur la couche de transport de trous 22.

Les couches de transport de trous 22 et de blocage d'électrons 23 présentent une épaisseur constante d'environ 10 à 30 nanomètres chacune.

La couche organique 20 comprend également une couche élémentaire émissive 24 déposée sur la couche de blocage d'électrons 23, une couche élémentaire de blocage de trous 25 déposée sur la couche émissive 24 et une couche élémentaire de transport d'électrons 26 déposée sur la couche de blocage de trous 25.

La couche émissive 24 est une couche organique formée par exemple de Alq3 tris-(8-hydroxyquinoline) aluminium. Elle présente une épaisseur qui varie entre ses extrémités, c'est-à-dire entre son côté latéral 15 et son côté latéral opposé 16.

En particulier, l'épaisseur de la couche émissive 24 augmente de façon progressive, graduelle et continue et présente une épaisseur minimale au niveau de la valeur minimale de l'échelle 12 et une épaisseur maximale au niveau de la valeur maximale de l'échelle 12.

L'augmentation de l'épaisseur de la couche émissive 24 est propre à augmenter le seuil de déclenchement de l'émetteur 6, comme décrit dans la suite de la description.

Ainsi, la couche émissive 24 présente une partie 38 de couche émissive adjacente au côté latéral 15, appelée première extrémité, et une partie 40 de couche émissive adjacente au côté latéral 16, appelée seconde extrémité, dont les épaisseurs sont différentes. En particulier, l'épaisseur de la partie 38 est inférieure à l'épaisseur de la partie 40.

Par exemple, l'épaisseur de la première partie 38 de la couche émissive 24 est égale à 10 nanomètres et l'épaisseur de la seconde partie 40 de la couche émissive 24 est égale à 100 nanomètres.

La couche de blocage de trous 25 et la couche de transport d'électrons 26 ont une épaisseur constante supérieure à 2 nanomètres et à 20 nanomètres respectivement.

La cathode 21 est constituée par une couche réflective conductrice 21 réalisée par exemple dans un matériau métallique. Elle est connectée à la cathode des moyens de fourniture de tension 8. Elle présente une épaisseur constante comprise entre 100 et 200 nanomètres. Elle est déposée sur l'ensemble de la surface de la couche de transport d'électrons 26.

En variante, l'épaisseur de la première partie 38 de la couche émissive est supérieure à 10 nanomètres.

En variante, l'épaisseur de la seconde partie 40 de la couche émissive est inférieure à 100 nanomètres.

Dans une variante inventive, l'épaisseur de la couche émissive 24 est constante et l'épaisseur de l'une quelconque des couches parmi la couche de transport de trous 22 et/ou la couche de blocage d'électrons 23 et/ou la couche de blocage de trous 25 et/ou la couche de transport d'électrons 26, varient entre les deux extrémités de l'émetteur 4.

En variante, l'épaisseur de la couche émissive 24 croît de façon exponentielle entre la partie 38 et la partie 40 de sorte que la surface d'affichage 11 s'illumine sur une zone correspondant à l'exponentiel de la valeur du signal d'entrée.

En fonctionnement, les moyens de fourniture 8 réceptionnent initialement une valeur d'entrée V_{data1} d'un signal d'entrée et génère une tension V1 de valeur correspondant à la valeur d'entrée V_{data1}.

Lorsque la tension V1 est appliquée entre l'anode 19 et la cathode 21, des trous et des électrons sont injectés par l'anode et respectivement par la cathode dans la couche organique 20.

Les trous et les électrons injectés se recombinent dans la couche organique émissive de lumière 24 pour former des excitons. Ceux-ci se désexcitent en émettant des photons dans la direction A de sorte que la surface d'affichage 11 est éclairée.

Une partie de longueur prédéfinie de la couche émissive 24 émet des photons lorsque la valeur de tension appliquée entre l'anode 19 et la cathode 21 est supérieure au seuil de déclenchement de cette partie de la couche émissive 24.

Lorsque la tension V1 de valeur par exemple égale à 2,5 V, est appliquée entre l'anode 19 et la cathode 21, une portion 49 de la surface d'affichage s'éclaire comme visible sur les figures 1 et 2 de sorte que la valeur du signal d'entrée V_{data1} correspondant à la tension V1 peut être lue sur l'échelle 12 par l'utilisateur.

La portion 49 correspond à la partie de la couche émissive 24 dont le seuil de déclenchement est inférieur à V1 et qui possède une épaisseur inférieure à une première valeur donnée.

Puis, les moyens de fourniture 8 réceptionnent une valeur d'entrée V_{data2} d'un signal d'entrée et génère une tension V2 de valeur correspondant à la valeur d'entrée V_{data2}.

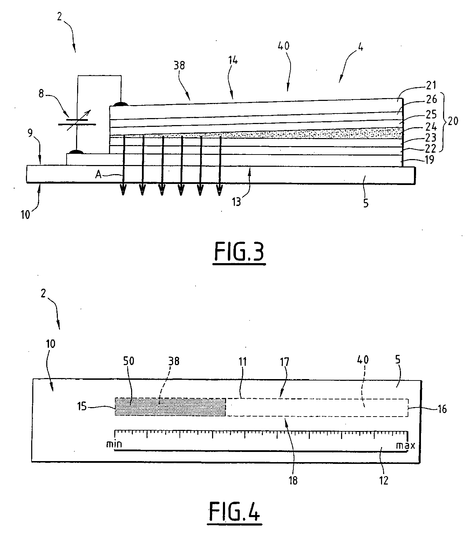

Lorsque la tension V2 de valeur par exemple égale à 2,8 V, est appliquée entre l'anode 19 et la cathode 21, une portion 50 de la surface d'affichage s'éclaire, comme visible sur les figures 3 et 4. La portion 50 possède une épaisseur inférieure à une seconde valeur donnée, la seconde valeur étant supérieure à la première valeur.

Comme la valeur de la tension V2 est supérieure à la valeur de la tension V1, la portion 50 s'étend sur une longueur plus importante de la surface d'affichage que la portion 49. En effet, une plus grande partie de la couche émissive 24 comporte un seuil de déclenchement inférieur à la tension V2.

Ainsi, le dispositif d'affichage 2 donne une représentation visuelle des valeurs V_{data1} et V_{data2} du signal d'entrée.

Avantageusement, ce dispositif d'affichage ne nécessite pas de circuit de commande de sorte qu'il est plus simple à fabriquer et moins coûteux.

Avantageusement, ce dispositif d'affichage est compact.

## Revendications

1. Emetteur de lumière (4) comprenant deux électrodes (19, 21) en regard l'une de l'autre et une couche (20) intercalée entre ces électrodes qui est propre à émettre de la lumière, dont l'épaisseur varie continûment entre une première extrémité (15) et une deuxième extrémité (16), où l'épaisseur de ladite première extrémité (15) est inférieure à l'épaisseur de la seconde extrémité (16) et où la tension de seuil de déclenchement de ladite première extrémité est inférieure à la tension de seuil de déclenchement de ladite deuxième extrémité de la couche (20), **caractérisé en ce que** de ladite couche (20) propre à émettre de la lumière est organique et comprend une couche élémentaire organique émissive (24) dont l'épaisseur est constante et au moins une couche élémentaire organique (22, 23, 25, 26) dont l'épaisseur varie entre lesdites première (15) et deuxième (16) extrémités de l'émetteur et qui est choisie parmi une couche de transport des électrons (26), une couche de transport des trous (22), une couche de blocage des trous (25) et une couche de blocage des électrons (23).

2. Emetteur de lumière (4) selon la revendication 1, **caractérisé en ce que** l'épaisseur de la première extrémité (15) de la couche organique (20) est supérieure ou égale à 10 nanomètres.

3. Emetteur de lumière (4) selon l'une quelconque des revendications 1 à 2, **caractérisé en ce que** l'épaisseur de la seconde extrémité (16) de la couche organique (20) est inférieure ou égale à 100 nanomètres.

4. Dispositif d'affichage (2) comportant au moins un émetteur de lumière (4) selon l'une quelconque des revendications 1 à 3, et un support (5) de fixation de l'émetteur de lumière (4), **caractérisé en ce qu'**il comporte en outre des moyens (8) de fourniture d'une tension variable connectés à la première (19) et à la seconde (21) électrodes, les moyens de fourniture (8) étant aptes à générer une première tension (V1) et une seconde tension (V2) supérieure à la première tension (V1), la couche organique (20) comprenant au moins une première (15) et une seconde (16) parties agencées entre les deux mêmes électrodes (19, 21), et **en ce que** seule la première partie (15) de la couche organique est apte à émettre de la lumière, lorsque la première tension (V1) est appliquée entre les électrodes (19, 21) et **en ce que** la première (15) et la seconde (16) parties de la couche organique sont aptes à émettre de la lumière lorsque la seconde tension (V2) est appliquée entre les électrodes (19, 21).

5. Dispositif d'affichage (2) selon la revendication 4, **caractérisé en ce que** les moyens de fourniture (8) comportent une entrée propre à recevoir un signal d'entrée et au moins une sortie apte à délivrer une tension de sortie variable, la valeur de la tension de sortie étant propre à correspondre à la valeur du signal d'entrée de sorte que le dispositif d'affichage (2) est apte à donner une représentation visuelle de la valeur du signal d'entrée.

## Claims

1. Light emitter (4) comprising two electrodes (19, 21) facing each other and a layer (20) interposed between these electrodes which is able to emit light and whose thickness varies continuously between a first end (15) and a second end (16), where the thickness of said first end (15) is less than the thickness of the second end (16) and where the trigger threshold voltage of said first end is less than the trigger threshold voltage of said second end of the layer (20) **characterised in that** said layer (20) able to emit light is organic and comprises an organic elementary emitting layer (24) whose thickness is constant and at least one organic elementary layer (22, 23, 25, 26) whose thickness varies between said first (15) and second (16) ends of the emitter and which is chosen from among an electron transport layer (26), a hole transport layer (22), a hole blocking layer (25) and an electron blocking layer (23).

2. Light emitter (4) according to claim 1, **characterised in that** the thickness of the first end (15) of the organic layer (20) is greater than or equal to 10 nanometres.

3. Light emitter (4) according to any one of claims 1 to 2, **characterised in that** the thickness of the second end (16) of the organic layer (20) is less than or equal to 100 nanometres.

4. Display device (2) comprising at least one light emitter (4) according to any of claims 1 to 3, and a fixing support (5) of the light emitter (4), **characterised in that** it also comprises means (8) for supplying a variable voltage connected to the first (19) and the second (21) electrodes, the supply means (8) being capable of generating a first voltage (V1) and a second voltage (V2) greater than the first voltage (V1), the organic layer (20) comprising at least a first (15) and a second (16) part arranged between the two same electrodes (19, 21), and **in that** only the first part (15) of the organic layer is capable of emitting light, when the first voltage (V1) is applied between the electrodes (19, 21) and **in that** the first (15) and the second (16) parts of the organic layer are capable of emitting light when the second voltage (V2) is applied between the electrodes (19, 21).

5. Display device (2) according to claim 4, **characterised in that** the supply means (8) comprise an input able to receive an input signal and at least one output capable of supplying a variable output voltage, the value of the output voltage being able to correspond to the value of the input signal so that the display device (2) is capable of providing a visual representation of the value of the input signal

## Patentansprüche

1. Lichtemitter (4) mit zwei einander gegenüber angeordneten Elektroden (19, 21) und einer zwischen diesen Elektroden angeordneten Schicht (20), die geeignet ist, Licht zu emittieren, deren Dicke kontinuierlich zwischen einem ersten Ende (15) und einem zweiten Ende (16) variiert, bei der die Dicke des ersten Endes (15) geringer ist als die Dicke des zweiten Endes (16) und bei der die Triggerschwellenspannung des ersten Endes geringer ist als die Triggerschwellenspannung des zweiten Endes der Schicht (20), **dadurch gekennzeichnet, dass** die Schicht (20), die geeignet ist, Licht zu emittieren, organisch ist und eine emittierende organische Elementarschicht (24), deren Dicke konstant ist, und mindestens eine organische Elementarschicht (22, 23, 25, 26) umfasst, deren Dicke zwischen dem ersten Ende (15) und dem zweiten Ende (16) des Emitters variiert und die unter einer Elektronentransportschicht (26), einer Löchertransportschicht (22), einer Löcherblockierschicht (25) und einer Elektronenblockierschicht (23) gewählt ist.

2. Lichtemitter (4) nach Anspruch 1, **dadurch gekennzeichnet, dass** die Dicke des ersten Endes (15) der organischen Schicht (20) größer oder gleich 10 Nanometer ist.

3. Lichtemitter (4) nach einem beliebigen der Ansprüche 1 bis 2, **dadurch gekennzeichnet, dass** die Dicke des zweiten Endes (16) der organischen Schicht (20) geringer oder gleich 100 Nanometer ist.

4. Anzeigevorrichtung (2) mit mindestens einem Lichtemitter (4) nach einem beliebigen der Ansprüche 1 bis 3 und einem Träger (5) für die Befestigung des Lichtemitters (4), **dadurch gekennzeichnet, dass** sie ferner Mittel (8) für die Bereitstellung einer variablen Spannung aufweist, welche an die erste (19) und an die zweite (21) Elektrode angeschlossen sind, wobei die Bereitstellungsmittel (8) geeignet sind, eine erste Spannung (V1) und eine zweite Spannung (V2), die größer ist als die erste Spannung (V1), zu erzeugen, wobei die organische Schicht (20) mindestens einen ersten Teil (15) und einen zweiten Teil (16) umfasst, welche zwischen den zwei selben Elektroden (19, 21) angeordnet sind, und dass lediglich der erste Teil (15) der organischen Schicht geeignet ist, Licht zu emittieren, wenn die erste Spannung (V1) zwischen den Elektroden (19, 21) angelegt ist, und dass der erste Teil (15) und der zweite Teil (16) der organischen Schicht geeignet sind, Licht zu emittieren, wenn die zweite Spannung (V2) zwischen den Elektroden (19, 21) angelegt ist.

5. Anzeigevorrichtung (2) nach Anspruch 4, **dadurch gekennzeichnet, dass** die Bereitstellungsmittel einen Eingang aufweisen, der geeignet ist, ein Eingangssignal zu empfangen, und mindestens einen Ausgang aufweisen, der geeignet ist, eine variable Ausgangsspannung abzugeben, wobei der Wert der Ausgangsspannung geeignet ist, dem Wert des Eingangssignals zu entsprechen, so dass die Anzeigevorrichtung (2) geeignet ist, eine optische Darstellung des Werts des Eingangssignals zu geben.
